# EUROPÄISCHE PATENTANMELDUNG

(11) **EP 4 123 903 A1**
(43) Veröffentlichungstag der Anmeldung: **25.01.2023**
(21) Anmeldenummer: 22182861.9
(22) Anmeldetag: 04.07.2022
(51) Int. Cl.: H03K 17/18

(54) **VERFAHREN ZUM ÜBERWACHEN EINES SCHALTBAREN HALBLEITERBAUELEMENTS UND ÜBERWACHUNGSVORRICHTUNG FÜR EIN HALBLEITERBAUELEMENT**

(30) Priorität: 21.07.2021 DE 102021118817
(71) Anmelder: Lisa Dräxlmaier GmbH, 84137 Vilsbiburg (DE)
(72) Erfinder: Rapolder, Thomas, 85560 Ebersberg (DE); Wortberg, Michael, 84405 Dorfen (DE)

(57) **Zusammenfassung**

Die vorliegende Erfindung bezieht sich auf ein Verfahren zum Überwachen eines schaltbaren Halbleiterbauelements (Q1) mit einer parallel zu dem Halbleiterbauelement (Q1) geschalteten Schutzschaltung (124), wobei eine an dem Halbleiterbauelement (Q1) und der Schutzschaltung (124) anliegende elektrische Größe (114) abgegriffen wird, und eine Beschädigung des Halbleiterbauelements (Q1) und/oder der Schutzschaltung (124) erkannt wird, wenn die elektrische Größe (114) größer als ein vorbekannter kritischer Wert (116) ist.

## Beschreibung

### Technisches Gebiet

Die vorliegende Erfindung betrifft ein Verfahren zum Überwachen eines schaltbaren Halbleiterbauelements, sowie eine Überwachungsvorrichtung für ein Halbleiterbauelement.

### Stand der Technik

Die vorliegende Erfindung wird im Folgenden hauptsächlich in Verbindung mit schaltbaren Halbleiterbauelementen beschrieben.

Bei einem Halbleiterbauelement, welches eine induktive Last schaltet, kann es aufgrund einer Induktivität der Last beim Abschalten zu einer Überspannung kommen. Die Induktivität wirkt dabei als Energiespeicher, der beim Abschalten entladen wird.

Die Überspannung kann so hoch sein, dass das Halbleiterbauelement beim Abschalten beschädigt werden kann. Insbesondere kann die Überspannung höher als eine Durchbruchspannung des Halbleiterbauelements sein. Dann brechen im Halbleiterbauelement Ladungsträger lawinenartig durch eine eigentlich sperrende Schicht des Halbleiterbauelements. Bei dem lawinenartigen Durchbruch können große Stromstärken erreicht werden. Durch die hohen Stromstärken kann sich das Halbleiterbauelement stark erwärmen und irreversibel thermisch geschädigt werden.

Das Halbleiterbauelement kann eventuell noch einmal leitend geschalten werden, ein erneuter Abschaltvorgang kann jedoch unmöglich sein.

Das Halbleiterbauelement kann beispielsweise dazu verwendet werden, eine autonome beziehungsweise teilautonome Funktion eines Elektrofahrzeugs zu aktivieren und deaktivieren. Wenn das Halbleiterbauelement beschädigt wird, kann die Funktion nicht mehr sicher abgeschaltet werden.

Um ein Erreichen der Durchbruchspannung zu verhindern kann eine Schutzschaltung parallel zu dem Halbleiterbauelement geschaltet werden. Die Schutzschaltung wird bei einer geringeren Spannung leitend als die Durchbruchspannung des Halbleiterbauelements. Wenn die Überspannung größer als eine Auslegungsspannung der Schutzschaltung ist, kann die Überspannung über die Schutzschaltung abgebaut werden.

### Beschreibung der Erfindung

Eine Aufgabe der Erfindung ist es daher, unter Einsatz konstruktiv möglichst einfacher Mittel ein verbessertes Verfahren zum Überwachen eines schaltbaren Halbleiterbauelements, sowie eine verbesserte Überwachungsvorrichtung für ein Halbleiterbauelement bereitzustellen. Eine Verbesserung kann hierbei beispielsweise eine verbesserte Erkennung einer Bauteilschädigung betreffen.

Die Aufgabe wird durch die Gegenstände der unabhängigen Ansprüche gelöst. Vorteilhafte Weiterbildungen der Erfindung sind in den abhängigen Ansprüchen, der Beschreibung und der begleitenden Figur angegeben.

Bei dem hier vorgestellten Ansatz wird eine Höhe einer Überspannung an einem Halbleiterbauelement gemessen und anhand von hinterlegten Maximalwerten für das Halbleiterbauelement erkannt, ob mit einer hohen Wahrscheinlichkeit eine Schädigung des Halbleiterbauelements eingetreten ist.

Insbesondere in einem Elektrofahrzeug kann der hier vorgestellte Ansatz verwendet werden, um kritische Funktionen des Elektrofahrzeugs abzusichern. Eine kritische Funktion kann beispielsweise ein autonomer oder teilautonomer Fahrbetrieb des Elektrofahrzeugs sein. Die kritische Funktion kann beispielsweise nicht mehr zur Verfügung gestellt werden, wenn das Halbleiterbauelement mit einer hohen Wahrscheinlichkeit während des letzten Abschaltvorgangs beschädigt wurde. So können unkontrollierbare Situationen sicher vermieden werden.

Es wird ein Verfahren zum Überwachen eines schaltbaren Halbleiterbauelements mit einer parallel zu dem Halbleiterbauelement geschalteten Schutzschaltung vorgeschlagen, wobei eine an dem Halbleiterbauelement und der Schutzschaltung anliegende elektrische Größe abgegriffen wird, und eine Beschädigung des Halbleiterbauelements und/oder der Schutzschaltung erkannt wird, wenn die elektrische Größe größer als ein vorbekannter kritischer Wert ist.

Weiterhin wird eine Überwachungsvorrichtung für ein Halbleiterbauelement mit einer parallel zu dem Halbleiterbauelement geschalteten Schutzschaltung vorgeschlagen, wobei die Überwachungsvorrichtung parallel zu dem Halbleiterbauelement und der Schutzschaltung geschaltet ist, wobei eine Abgreifeinrichtung der Überwachungsvorrichtung dazu ausgebildet ist, eine an dem Halbleiterbauelement und der Schutzschaltung anliegende elektrische Größe abzugreifen und eine Auswerteeinrichtung der Überwachungsvorrichtung dazu ausgebildet ist, die elektrische Größe mit einem vorbekannten kritischen Wert zu vergleichen, um eine Beschädigung des Halbleiterbauelements und/oder der Schutzschaltung zu erkennen.

Unter einem schaltbaren Halbleiterbauelement kann beispielsweise ein Transistor oder Thyristor verstanden werden. Das Halbleiterbauelement kann insbesondere ein MOSFET sein. Das Halbleiterbauelement kann zum Einschalten und Ausschalten einer elektrischen Last verwendet werden. Das Halbleiterbauelement kann beispielsweise zwischen der Last und einer Energiequelle angeordnet sein. Das Halbleiterbauelement kann durch eine Steuerung elektrisch angesteuert werden. Beispielsweise kann das Halbleiterbauelement durch Anlegen einer Steuerspannung an einen Steuerungsanschluss (Gate) des Halbleiterbauelements leitend geschalten werden. Wenn die Steuerspannung unterbrochen wird, wird das Halbleiterbauelement sperrend geschalten.

Das Halbleiterbauelement kann einen bauartbedingten Betriebsbereich aufweisen. Insbesondere kann das Halbleiterbauelement für einen maximal übertragbaren elektrischen Stromfluss und eine maximal sperrbare elektrische Spannung konfiguriert sein. Die Grenzen des Betriebsbereichs können als kritische Werte hinterlegt sein. Bei einem Stromfluss größer als der maximal übertragbare Stromfluss kann das Halbleiterbauelement überhitzen. Bei einer Spannung um einen Sicherheitsfaktor größer als die maximal sperrbare Spannung kann es zu einem Lawinendurchbruch durch einen sperrenden Bereich des Halbleiterbauelements kommen.

Der Stromfluss und die Spannung am Halbleiterbauelement sind erfassbare elektrische Größen. Der Stromfluss beziehungsweise die Spannung können gemessen werden und als Stromflusswert beziehungsweise Spannungswert abgebildet werden. Der Stromfluss beziehungsweise die Spannung können insbesondere digitalisiert werden. Der Stromflusswert beziehungsweise Spannungswert kann mit dem entsprechenden kritischen Wert verglichen werden, um die mögliche Beschädigung zu erkennen.

Die Überwachungsvorrichtung kann eine Speichereinrichtung zum Speichern eines Maximums der elektrischen Größe aufweisen. Die Abgreifeinrichtung kann parallel zu einer Speicherkomponente der Speichereinrichtung geschaltet sein. Die Abgreifeinrichtung kann dazu ausgebildet sein, als die elektrische Größe das in der Speicherkomponente gespeicherte Maximum zeitversetzt abzugreifen. Das Maximum der elektrischen Größe kann insbesondere bei einem Abschalten des Halbleiterbauelements unter Verwendung der zum Halbleiterbauelement parallelgeschalteten Speichereinrichtung gespeichert werden. Das Maximum kann zeitversetzt an der Speichereinrichtung abgegriffen werden. Die Beschädigung kann erkannt werden, wenn das Maximum größer als der kritische Wert ist. Eine Speichereinrichtung kann als Sample&Hold-Einheit bezeichnet werden.

Die Speichereinrichtung kann eine Diode, einen parallel zur Diode geschalteten Widerstand und einen in Reihe zu der Diode und dem Widerstand geschalteten Kondensator aufweisen. Der Kondensator kann die Speicherkomponente der Speichereinrichtung sein. Die Abgreifeinrichtung kann parallel zu dem Kondensator geschaltet sein und eine am Kondensator anliegende Spannung abgreifen. Die Speichereinrichtung kann das Maximum der Spannung unabhängig von einem Zeitpunkt seines Auftretens speichern, da die Speichereinrichtung zeitkontinuierlich mit dem Halbleiterbauelement verbunden ist. Die Speichereinrichtung kann mit anderen Worten analog sein. Die Abgreifeinrichtung kann einen analog zu digital Konverter beinhalten. Die Abgreifeinrichtung kann getaktet auslesen. Ein Digitalisierungszeitpunkt der Abgreifeinrichtung kann zeitversetzt zu dem Maximum sein. Durch die Speichereinrichtung kann das Maximum bis zum Auslesezeitpunkt gespeichert werden. Dies ist besonders vorteilhaft, da die Messgröße, hier die Spitze der Drain-Source Spannung des schaltbaren Halbleiterelementes (Mosfet), nur für einige µs anliegt und eine zeitlich koinzidente Messung damit nicht möglich ist.

Wenn durch die Überwachungsschaltung über das schaltbare Halbleiterelement eine Spannung gemessen wird, die auf einen Lawinendurchbruch schließen lässt (bei 40 V Mosfets ca. 45 V), dann lässt dies auf eine Beschädigung der Schutzbeschaltung schließen. Wenn die Beschädigung erkannt wird, kann eine Beschädigungsmeldung ausgegeben werden. Die Beschädigungsmeldung kann in der Steuerung des Halbleiterbauelements hinterlegt werden. Aufgrund der Beschädigungsmeldung kann beispielsweise zeitnah eine Reparatur veranlasst werden.

Eine zukünftige Verwendung des Halbleiterbauelements kann durch einen Sperrvermerk an eine Steuerung des Halbleiterbauteils verhindert werden, wenn die Beschädigung erkannt wird. Die durch das Halbleiterbauelement geschaltete Last kann nach der Beschädigung nicht mehr verwendet werden, um einen unkontrollierten Zustand zu vermeiden. Dabei können beispielsweise sicherheitskritische Funktionen eines Fahrzeugs deaktiviert werden, nachdem die Beschädigung erkannt worden ist.

Die Schutzschaltung kann eine zu dem Halbleiterbauelement parallel geschaltete Suppressordiode umfassen. An der Suppressordiode kann eine elektrische Spannung abgegriffen werden. Eine Beschädigung der Suppressordiode kann erkannt werden, wenn die Spannung größer als eine Durchbruchspannung plus eine erlaubte Spannungstoleranz der Suppressordiode ist. Eine Suppressordiode kann als Transil-Diode bezeichnet werden. Die Suppressordiode kann ab einer Durchbruchspannung ohne äußere Ansteuerung leitend werden. Die Durchbruchspannung der Suppressordiode kann kleiner sein als eine Durchbruchspannung des Halbleiterbauelements. Dadurch kann Spannung über die Suppressordiode abgebaut werden und Strom durch die Suppressordiode fließen, wenn die anliegende Spannung größer als die Durchbruchspannung der Suppressordiode ist, jedoch noch kleiner als die Durchbruchspannung des Halbleiterbauelements.

Die Beschädigung der Suppressordiode kann erkannt werden, wenn die Spannung um eine Spannungstoleranz größer als die Durchbruchspannung plus eine erlaubte Spannungstoleranz der Suppressordiode ist. Die Suppressordiode kann eine höhere Spannung aushalten als ihre Durchbruchspannung. Durch eine Spannungstoleranz können Fehlerkennungen von Beschädigungen vermieden werden. Die Spannungstoleranz kann kleiner sein als eine Differenz zwischen der Durchbruchspannung des Halbleiterbauelements und der Durchbruchspannung der Suppressordiode.

Eine Beschädigung des Halbleiterbauelements kann erkannt werden, wenn die Spannung um eine Toleranz größer als eine Spannungsfestigkeit des Halbleiterbauelements ist. Die Spannungsfestigkeit plus Toleranz können insbesondere einer Durchbruchspannung des Halbleiterbauelements entsprechen. Das Halbleiterbauelement kann geschädigt werden, wenn seine Durchbruchspannung erreicht wird. Wenn die Durchbruchspannung erreicht wird und der Durchbruch erfolgt, kann sich das Halbleiterbauelement insbesondere stärker als bestimmungsgemäß erwärmen.

### Kurze Figurenbeschreibung

Nachfolgend wird ein vorteilhaftes Ausführungsbeispiel der Erfindung unter Bezugnahme auf die begleitende Figur erläutert. Es zeigt:

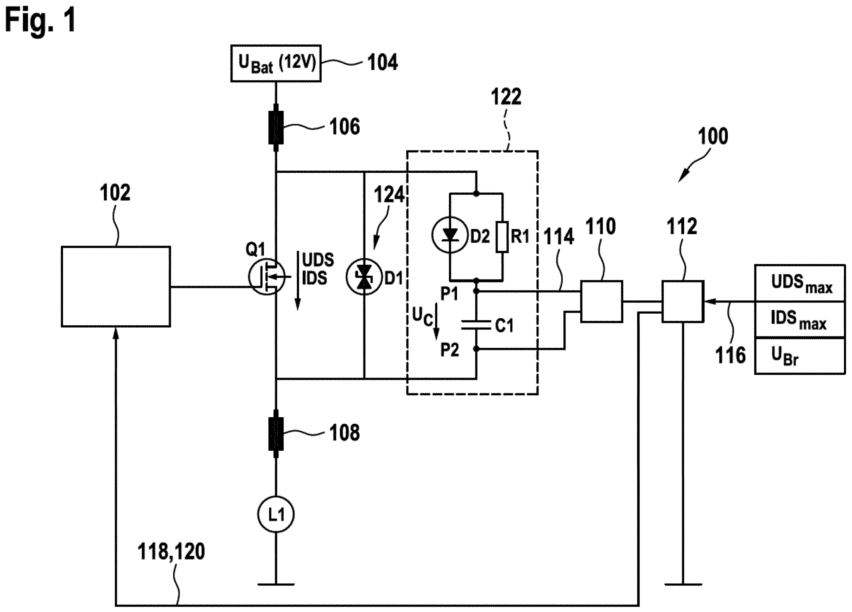

Fig. 1 einen Schaltplan einer Überwachungsvorrichtung für ein Halbleiterbauelement gemäß einem Ausführungsbeispiel.

Die Figur ist lediglich eine schematische Darstellung und dient nur der Erläuterung der Erfindung. Gleiche oder gleichwirkende Elemente sind durchgängig mit den gleichen Bezugszeichen versehen.

### Detaillierte Beschreibung

Fig. 1 zeigt einen Schaltplan einer Überwachungsvorrichtung 100 für ein Halbleiterbauelement Q1 gemäß einem Ausführungsbeispiel. Das Halbleiterbauelement Q1 ist hier ein schaltbarer MOSFET und wird über eine Steuerung 102 angesteuert. Das Halbleiterbauelement Q1 ist zwischen einer Energiequelle 104 für elektrische Energie und einer Last L1 angeordnet. Die Last L1 kann eine induktive Last L1 sein.

Zwischen der Energiequelle 104 und dem Halbleiterbauelement Q1 ist ein Leitungssatz Anschluss 106 angeordnet. Zwischen dem Halbleiterbauelement Q1 und der Last L1 ist ein Leitungssatz Verbraucher 108 angeordnet. Der Leitungssatz Anschluss 106 und der Leitungssatz Verbraucher 108 können jeweils eine individuelle Induktivität aufweisen.

Die Energiequelle 104 kann beispielsweise eine Batterie eines Elektrofahrzeugs mit einer Batteriespannung UBat sein. Die Batteriespannung UBat kann beispielsweise 12 Volt betragen. Die Last L1 kann beispielsweise ein Funktionsmodul des Elektrofahrzeugs sein. Insbesondere kann die Last L1 ein Funktionsmodul für einen autonomen beziehungsweise teilautonomen Betrieb des Elektrofahrzeugs sein.

Wenn das Halbleiterbauelement Q1 von der Steuerung 102 leitend geschaltet wird, ist die Last L1 über den Leitungssatz Anschluss 106, das Halbleiterbauelement Q1 und den Leitungssatz Verbraucher 108 elektrisch leitend mit der Energiequelle 104 verbunden.

Das Halbleiterelement Q1 sichert die Leitung zur Last L1 gegen Kurzschluss ab, um eine thermische Überlast der Leitung zu verhindern. Wenn ein Kurzschluss auf der Leitung zur Last oder in der Last selbst auftritt, dann nimmt der Strom sehr schnell zu. Übersteigt der Strom eine Abschalt-Stromschwelle, so wird das Halbleiterbauelement Q1 von der Steuerung 102 sperrend geschaltet. Wenn der Lastpfad unter Kurzschluss unterbrochen wird, entladen sich die Induktivitäten der Lastleitung 108 und der Zuleitung 106 schlagartig. Dadurch steigt eine elektrische Spannung UDS am Halbleiterbauelement Q1 kurzzeitig über die Batteriespannung UBat. Es kommt also zu einer Spanungsspitze. Eine Höhe der Spannungsspitze ist abhängig von den Induktivitäten und der Zuleitung 106 und der Lastleitung 108.

Wenn die Spannung UDS um mehr als eine Toleranz größer als eine Spannungsfestigkeit UDSmax des Halbleiterbauelements Q1 ist, kommt es zu einem sogenannten Lawinendurchbruch im Halbleiterbauelement Q1 und die Spannungsspitze wird durch das eigentlich gesperrte Halbleiterbauelement Q1 abgebaut. Dabei kann kurzzeitig eine große Leistung Pv = I_K * Durchbruchsspannung Halbleiterelement im Halbleiterelement umgesetzt werden, wobei I_K im Abschaltmoment dem Strom der Kurzschluss-Abschaltschwelle entspricht. Dieser Stromfluss nimmt linear ab, bis die in den Induktivitäten gespeicherte Energie W=1/2 (L Zuleitung + L Lastleitung) * I_K² abgebaut ist. Die im Halbleiterelement umgesetzte Energie erwärmt das Halbleiterbauelement Q1 und kann das Halbleiterbauelement Q1 schädigen, wenn die maximale Sperrschichttemperatur von typischerweise 170° C überschritten wird.

Die Überwachungsvorrichtung 100 ist parallel zu dem Halbleiterbauelement Q1 geschaltet. Die Überwachungsvorrichtung 100 weist eine Abgreifeinrichtung 110 und eine Auswerteeinrichtung 112 auf. Die Abgreifeinrichtung 110 ist dazu ausgebildet, eine elektrische Größe 114 am Halbleiterbauelement Q1 abzugreifen. Die elektrische Größe 114 ist die Spannung UDS. Die Abgreifeinrichtung 110 ist dazu ausgebildet, die elektrische Größe 114 zu digitalisieren. Die Auswerteeinrichtung 112 ist dazu ausgebildet, einen Wert der elektrischen Größe 114 mit zumindest einem hinterlegten kritischen Wert 116 zu vergleichen. Der kritische Wert 116 kann dabei die Spannungsfestigkeit UDSmax Die Auswerteeinrichtung 108 erkennt eine wahrscheinliche Beschädigung des Halbleiterbauelements Q1, wenn die elektrische Größe 114 größer als der kritische Wert 116 ist.

Wenn die elektrische Größe 114 größer als die Spannungsfestigkeit UDSmax plus Toleranz oder die Stromtragfähigkeit IDSmax des Halbleiterbauelements Q1 ist, wird in einem Ausführungsbeispiel die erkannte beziehungsweise wahrscheinliche Beschädigung des Halbleiterbauelements Q1 in einer Beschädigungsmeldung 118 dokumentiert. Die Beschädigung kann auch erst dokumentiert werden, wenn der elektrische Stromfluss IDS um eine Toleranz höher als die Stromtragfähigkeit IDSmax ist. Die Beschädigungsmeldung wird beispielsweise in der Steuerung 102 hinterlegt.

Um eine Verwendung des vorgeschädigten Halbleiterbauelements Q1 zu verhindern, wird in einem Ausführungsbeispiel beim Erkennen der Beschädigung ein Sperrvermerk 120 an die Steuerung 102 gesendet, um ein erneutes leitend Schalten des Halbleiterbauelements Q1 durch die Steuerung 102 zu blockieren.

In einem Ausführungsbeispiel weist die Überwachungsvorrichtung 100 eine Speichereinrichtung 122 auf. Die Speichereinrichtung 122 ist dazu ausgebildet, ein Maximum der elektrischen Größe 114 zu speichern. Die Abgreifeinrichtung 110 ist dabei parallel zu einer Speicherkomponente C1 der Speichereinrichtung 122 geschaltet. Die Speicherkomponente C1 ist ein Kondensator und die Abgreifeinrichtung 110 greift als die elektrische Größe 114 eine Spannung Uc am Kondensator ab.

Die Speichereinrichtung 122 weist ferner eine Diode D2 und einen Widerstand R1 auf. Die Diode D2 und der Widerstand R1 sind parallel zueinander geschaltet. Der Widerstand R1 ist sehr hochohmig und kann den Kondensator in einigen Sekunden entladen, damit dieser wieder für eine neue Messung zur Verfügung steht. Die Entlade-Zeitkonstante wird dabei um den Faktor typischerweise 20 bis 100 höher gewählt als die Maximale Verzögerung zwischen Abschaltmoment mit Spannungsspitze UDS und Messung über die Abgreifeinrichtung 110. Die Diode D2 und der Widerstand R1 sind in Reihe zu der Speicherkomponente C1 geschaltet.

In einem Ausführungsbeispiel ist eine Schutzschaltung 124 parallel zu dem Halbleiterbauelement Q1 geschaltet. Die Schutzschaltung 124 besteht hier aus einer Suppressordiode D1. Die Suppressordiode D1 weist eine niedrigere Durchbruchspannung UBr als die Spannungsfestigkeit UDSmax auf. Die Suppressordiode D1 weist eine höhere Energieaufnahmefähigkeit als das Halbleiterbauelement Q1 auf. Im Auslegungsfall kann die Spannungsspitze über die Schutzschaltung 124 abgeleitet werden, bevor der Lawinendurchbruch das Halbleiterbauelement Q1 schädigen kann. Durch die größere Energieaufnahmefähigkeit wird die Suppressordiode D1 im Kurzschlussfall nicht beschädigt.

Für eine sichere Auslegung der Schaltung ist es wünschenswert, den Ausfall der Schutzbeschaltung diagnostizieren zu können. Dann kann die Schutzschaltung 124 durch äußere Einwirkung thermisch beschädigt sein, oder es kommt zu einem zufälligen Ausfall der Komponente. Im beschädigten Zustand kann die Schutzschaltung 124 ihre Aufgabe eventuell nicht mehr erfüllen. Diese erhöhte Belastung wird durch die Überwachungsvorrichtung 100 registriert und ebenfalls in Form einer Beschädigungsmeldung 118 dokumentiert.

Die Beschädigung der Schutzschaltung 124 resultiert in einem Ausführungsbeispiel in einem Sperrvermerk 120 für die Steuerung 102, da das Abschalten des Halbleiterbauelements Q1 durch die beschädigte Schutzschaltung 124 nicht mehr abgesichert ist.

In einem Ausführungsbeispiel wird die Beschädigung der Schutzschaltung 124 erkannt, wenn die elektrische Größe 114 um eine Spannungstoleranz höher als die Durchbruchspannung UBr oder höher als die Stromtragfähigkeit der Schutzschaltung 124 ist.

Mit anderen Worten wird eine Diagnosevorrichtung für die Diagnose der Schutzbeschaltung von Halbleiter-Schaltelementen vorgestellt.

Bei Stromverteilern kann die Kombination aus Relais plus Schmelzsicherungen für eine elektronische Klemmenschaltung und konventionelle Absicherung der Lastkanäle durch MOSFET-Schalter ersetzt werden. Im Fall einer Kurzschlussabschaltung im aktiven Modus können die MOSFET durch eine sehr hohe induktive Überspannung geschädigt werden. Die Überspannung kann so hoch sein, dass die MOSFETS irreversibel geschädigt werden und sie unter Umständen nicht mehr trennen können. Für die Überspannungsfestigkeit kann daher eine Schutzbeschaltung beziehungsweise Schutzschaltung, z.B. aus Suppressordioden (Source nach Drain) vorgesehen werden. Es gibt aber Fälle, in denen die wirksame Induktivität beim Kurzschluss nicht wirklich bekannt ist und eine Auslegung der Schutzschaltung daher schwierig ist. Bei hohen Kurzschlussströmen kann zudem aufgrund des Kanalwiderstandes der Suppressordioden die kritische Energie für die Suppressordiode überschritten werden. Die Suppressordiode kann dadurch zerstört werden und bietet dann keinen Schutz für den MOSFET-Schalter mehr.

Bei dem hier vorgestellten Ansatz wird eine Diagnosemöglichkeit eingeführt, mit der die Schädigung erkannt werden kann. Dazu wird parallel zu dem MOSFET Kanal und der Suppressordiode ein Sample&Hold Glied geschaltet. Über eine Analog-Digital-Wandler-Stufe wird das abgegriffene Signal digitalisiert und einer Entscheider-Stufe in einem Mikroprozessor zugeführt. Je nach Überschreiten vordefinierter Schwellwerte kann eine Schädigung der Suppressordiode diagnostiziert werden.

So kann eine redundante Überspannungsabsicherung der MOSFETs (MOSFETs + Suppressor) für Kanäle mit funktionaler Sicherheit (FUSI Kanäle) mit Diversität erreicht werden. Ein Defekt der Suppressordiode durch ein Überspannungsereignis kann so erkannt werden. Dieses Ereignis kann an ein übergeordnetes System gemeldet werden.

Eine elektronische Sicherung besteht aus einem MOSFET-Schalter Q1, der MOSFET-Ansteuerung und einer zum MOSFET-Schalter Q1 parallel geschaltete Suppressordiode D1. Bei dem hier vorgestellten Ansatz ist eine Sample&Hold-Einheit parallel zum MOSFET-Kanal Q1 und der Suppressordiode D1 geschaltet. Die Sample&Hold-Einheit besteht aus einer als Diode D2, einem Widerstand R1 und einem Kondensator C1. Eine Auswerteeinheit mit einem Analog-Digital-Wandler ist parallel zum Kondensator C1 der Sample&Hold-Einheit angeschlossen. Die Auswerteeinheit kann diskret oder in einem Mikroprozessor ausgeführt sein.

Eine an den MOSFET-Schalter Q1 über einen Leitungssatz Verbraucher angeschlossene Last L1 kann über den MOSFET Q1 eingeschaltet bzw. ausgeschaltet werden. Mit weiteren Funktionen wie einer Drain-Source Spannungsmessung kann eine Steuerung des MOSFET Q1 zu einer intelligenten elektronischen Sicherung (eFuse) erweitert werden.

Beim Abschalten von induktiven Lasten werden Spannungen über die Drain-Source-Strecke induziert, die einen sicheren Betriebsbereich (Safe Operating Area) des MOSFET Q1 verletzen und zu dessen thermischen Zerstörung führen können. Typische Werte für die Drain-Source Spannungsfestigkeit UDSmax für diese Anwendung liegen bei 40 V. Um den MOSFET Q1 zu schützen, wird eine Suppressordiode D1, die die induzierten Spannungsverläufe, definiert durch den Leitungssatz Verbraucher und die Last L1 zuverlässig abbauen kann, parallel zum MOSFET Q1 geschaltet. Die Durchbruchspannung UBr der Suppressordiode D1 (typischerweise 32 V) liegt mit einem Sicherheitsabstand unter der Spannung UDSmax. Mit dem parallel geschalteten Sample&Hold-Glied und der Auswerteeinheit wird die auftretende Scheitelspannung Uc gemessen. Die Sample&Hold-Schaltung stellt sicher, dass die maximal aufgetretene Scheitelspannung Uc auch dann noch gemessen wird, wenn das Erreichen der maximalen Scheitelspannung Uc und der Samplezeitpunkt nicht unmittelbar zusammenfallen. Im Normalbetrieb wird die auftretende Überspannung beim Abschalten der induktiven Last L1 auf den Wert der Durchbruchspannung UBr reduziert. Die Auswerteeinheit wird immer den Spannungswert UBr zwischen P1 und P2 messen. Ändert sich durch unvorhersehbare Ereignisse der Lastfall, bestehend aus dem Leitungssatz Verbraucher und der Last L1, zu Ungunsten der ursprünglichen Auslegung, kann bzw. wird die Suppressordiode D1 zerstört und die Spannung steigt auf ca. UDSmax + 5 V also 45 V an und wird dann durch einen Lawinendurchbruch (Avalanche) des Mosfets Q1 begrenzt. Nach einem erfolgten Überlast-Abschaltvorgang misst der Mikrocontroller (µC) der Auswerteeinheit über den Analog-Digital-Konverter (ADC) die differentielle Spannung zwischen P1 und P2 nach jedem Abschaltvorgang. Die Zerstörung der Suppressordiode D1 kann diagnostiziert werden. Im normalen, lastfreien Abschaltfall wird die gemessene Spannung Uc gleich der Batteriespannung (12 V) sein. Im Last-Abschalt-Fall ohne Fehler wird UBr gemessen. Im Fall einer Zerstörung der Suppressordiode D1 wird die gemessene Spannung 45V sein.

Mit hoher Wahrscheinlichkeit kann davon ausgegangen werden, dass es sich um einen Multi-Point Fehler handelt, wenn die Suppressordiode D1 wegen Überlast versagt und der MOSFET Q1 gleichzeitig im Lawinendurchbruch (Avalanche) versagt. Der MOSFET Q1 wird im Fall des Versagens der Schutzschaltung bei einer richtigen Auslegung noch einmal ausschalten können, ohne durchzulegieren, allerdings wäre er dann vorgeschädigt. Der hier vorgestellte Ansatz ermöglicht nun die Erkennung des latenten Fehlers des Ausfalls der Schutzschaltung. Der Kanal mit dem MOSFET Q1 wird nach der Erkennung des Fehlers der Schutzschaltung von einer übergeordneten Logik nicht mehr aktiviert.

Wenn nur ein dauerhaft niederohmiger Fehler der Last L1 zur kritischen Situation führt, dann kann auf eine Differenzmessung P1 zu P2 verzichtet werden und nur eine Messung an P1 ist hinreichend, da P2 mit dem Fehler auf Masse-Potential liegt.

Da es sich bei der vorhergehend detailliert beschriebenen Vorrichtungen und Verfahren um Ausführungsbeispiele handelt, können sie in üblicher Weise vom Fachmann in einem weiten Umfang modifiziert werden, ohne den Bereich der Erfindung zu verlassen. Insbesondere sind die mechanischen Anordnungen und die Größenverhältnisse der einzelnen Elemente zueinander lediglich beispielhaft

### BEZUGSZEICHENLISTE

- 100: Überwachungsvorrichtung
- Q1: Halbleiterbauelement
- 102: Steuerung
- 104: Energiequelle
- L1: Last
- 106: Leitungssatz Anschluss
- 108: Leitungssatz Verbraucher
- UDS: Source-Drain Spannung
- UDSmax: Spannungsfestigkeit
- IDS: Source-Drain Stromfluss
- IDSmax: Stromtragfähigkeit
- 110: Abgreifeinrichtung
- 112: Auswerteeinrichtung
- 114: elektrische Größe
- 116: kritischer Wert
- 118: Beschädigungsmeldung
- 120: Sperrvermerk
- 122: Speichereinrichtung
- C1: Speicherkomponente
- Uc: Spannung
- D2: Diode
- R1: Widerstand
- 124: Schutzschaltung
- D1: Suppressordiode
- UBr: Durchbruchspannung

## Patentansprüche

1. Verfahren zum Überwachen eines schaltbaren Halbleiterbauelements (Q1) mit einer parallel zu dem Halbleiterbauelement (Q1) geschalteten Schutzschaltung (124), wobei eine an dem Halbleiterbauelement (Q1) und der Schutzschaltung (124) anliegende elektrische Größe (114) abgegriffen wird, und eine Beschädigung des Halbleiterbauelements (Q1) und/oder der Schutzschaltung (124) erkannt wird, wenn die elektrische Größe (114) größer als ein vorbekannter kritischer Wert (116) ist.

2. Verfahren gemäß Anspruch 1, bei dem ein Maximum der elektrischen Größe (114) bei einem Abschalten des Halbleiterbauelements (Q1) unter Verwendung einer zu dem Halbleiterbauelement (Q1) und der Schutzschaltung (124) parallel geschalteten Speichereinrichtung (122) gespeichert wird, wobei das Maximum zeitversetzt an der Speichereinrichtung (122) abgegriffen wird und die Beschädigung erkannt wird, wenn das Maximum größer als der kritische Wert (116) ist.

3. Verfahren gemäß einem der vorhergehenden Ansprüche, bei dem eine Beschädigungsmeldung (118) ausgegeben wird, wenn die Beschädigung erkannt wird.

4. Verfahren gemäß einem der vorhergehenden Ansprüche, bei dem eine zukünftige Verwendung des Halbleiterbauelements (Q1) durch einen Sperrvermerk (120) an eine Steuerung (102) des Halbleiterbauelements (Q1) verhindert wird, wenn die Beschädigung erkannt wird.

5. Verfahren gemäß einem der vorhergehenden Ansprüche, bei dem die Schutzschaltung (124) eine Suppressordiode (D1) umfasst und an der zu dem Halbleiterbauelement (Q1) parallel geschalteten Suppressordiode (D1) eine elektrische Spannung (UDS) abgegriffen wird, wobei eine Beschädigung der Suppressordiode (D1) erkannt wird, wenn die Spannung (UDS) größer als eine Durchbruchspannung (UBr) plus eine erlaubte Spannungstoleranz der Suppressordiode (D1) ist.

6. Verfahren gemäß Anspruch 5, bei dem die Beschädigung der Suppressordiode (D1) erkannt wird, wenn die Spannung (UDS) um eine Spannungstoleranz größer als die Durchbruchspannung (UBr) plus eine erlaubte Spannungstoleranz der Suppressordiode (D1) ist.

7. Verfahren gemäß einem der vorhergehenden Ansprüche, bei dem eine Beschädigung des Halbleiterbauelements (Q1) erkannt wird, wenn die Spannung (UDS) um eine Toleranz größer als eine Spannungsfestigkeit (UDSmax) des Halbleiterbauelements (Q1) ist.

8. Überwachungsvorrichtung (100) für ein Halbleiterbauelement (Q1) mit einer parallel zu dem Halbleiterbauelement (Q1) geschalteten Schutzschaltung (124), wobei die Überwachungsvorrichtung (100) parallel zu dem Halbleiterbauelement (Q1) und der Schutzschaltung (124) geschaltet ist, wobei eine Abgreifeinrichtung (110) der Überwachungsvorrichtung (100) dazu ausgebildet ist, eine an dem Halbleiterbauelement (Q1) und der Schutzschaltung (124) anliegende elektrische Größe (114) abzugreifen, und eine Auswerteeinrichtung (112) der Überwachungsvorrichtung (100) dazu ausgebildet ist, die elektrische Größe (114) mit einem vorbekannten kritischen Wert (116) zu vergleichen, um eine Beschädigung des Halbleiterbauelements (Q1) und/oder der Schutzschaltung (124) zu erkennen.

9. Überwachungsvorrichtung (100) gemäß Anspruch 8, mit einer Speichereinrichtung (122) zum Speichern eines Maximums der elektrischen Größe (114), wobei die Abgreifeinrichtung (110) parallel zu einer Speicherkomponente (C1) der Speichereinrichtung (122) geschaltet ist und dazu ausgebildet ist, als die elektrische Größe (114) das in der Speicherkomponente (C1) gespeicherte Maximum zeitversetzt abzugreifen.

10. Überwachungsvorrichtung (100) gemäß Anspruch 9, bei der die Speichereinrichtung (122) eine parallel zu einem Widerstand (R1) geschaltete Diode (D2) aufweist, wobei die Speicherkomponente (C1) eine in Reihe zu der Diode (D2) und dem Widerstand (R1) geschaltete Kapazität (C1) ist.
